# EUROPÄISCHE PATENTSCHRIFT

(11) **EP 0 919 015 B1**
(45) Veröffentlichungstag und Bekanntmachung des Hinweises auf die Patenterteilung: **15.11.2000**
(21) Anmeldenummer: 97942863.8
(22) Anmeldetag: 19.08.1997
(51) Int. Cl.: G03F 7/18, B05D 1/26, B05D 1/28, G03F 7/16

(54) **VERFAHREN UND VORRICHTUNG ZUM AUFTRAGEN VON FOTORESISTLACK AUF NICHT EBENE GRUNDKÖRPEROBERFLÄCHEN**
PROCESS AND DEVICE FOR APPLYING A PHOTORESIST LACQUER ON UNEVEN BASE BODY SURFACES
PROCEDE ET DISPOSITIF POUR L'APPLICATION DE PHOTORESIST SUR DES SURFACES DE SUBSTRAT NON PLANES

(30) Priorität: 19.08.1996 DE 19633407
(43) Veröffentlichungstag der Anmeldung: 02.06.1999
(73) Patentinhaber: FRAUNHOFER-GESELLSCHAFT ZUR FÖRDERUNG DER ANGEWANDTEN FORSCHUNG E.V., 80636 München (DE)
(72) Erfinder: LÜTHJE, Holger, D-25469 Halstenbeck (DE); DAAUD, Simone, D-38122 Braunschweig (DE); BÖTTCHER, Reinulf, D-33619 Bielefeld (DE)
(86) Internationale Anmeldenummer: EP9704510
(87) Internationale Veröffentlichungsnummer: WO9808144

(56) Entgegenhaltungen:
- EP-A- 0 440 079
- EP-A- 0 609 478
- EP-A- 0 641 648
- DE-A- 4 329 338
- DE-A- 4 339 493
- PATENT ABSTRACTS OF JAPAN vol. 012, no. 226 (P-722), 28.Juni 1988 & JP 63 019657 A (OKI ELECTRIC IND CO LTD), 27.Januar 1988,
- PATENT ABSTRACTS OF JAPAN vol. 096, no. 006, 28.Juni 1996 & JP 08 029615 A (SONY CORP), 2.Februar 1996,
- MATSUMOTO T ET AL: "FABRICATION OF A FIBER PROBE WITH A NANOMETRIC PROTRUSION FOR NEAR-FIELD OPTICAL MICROSCOPY BY A NOVEL TECHNIQUE OF THREE- DIMENSIONAL NANOPHOTOLITHOGRAPHY" JOURNAL OF LIGHTWAVE TECHNOLOGY, Bd. 14, Nr. 10, Oktober 1996, Seiten 2224-2230, XP000631521

## Beschreibung

Die Erfindung betrifft eine Vorrichtung und ein Verfahren zum Auftragen von Fotoresistlack auf Oberflächen eines Grundkörpers.

Aus der Halbleiterbeschichtung, insbesondere von Wafern sind Verfahren wie das Schleuder-, das Tauch- oder auch das Sprühverfahren zum Auftragen einer Fotoresistlackbeschichtung bekannt. Da insbesondere bei der Beschichtung von Wafem eine Belichtungszeit gewählt wird und damit die Dosis die Strukturgenauigkeit bestimmt, ist eine präzise Lackdicke sehr wichtig.

Im Schleuderverfahren beispielsweise wird der Wafer, nachdem der Fotoresistlack auf ihm möglichst zentral aufgetragen worden ist, rotiert. Dadurch verteilt sich der Fotoresistlack aufgrund der dann wirkenden Zentrifugalkräfte im wesentlichen gleichmäßig auf der Oberfläche des flachen Wafers.

Tauch- und Sprühverfahren können beispielsweise für dreidimensionale Substrate verwendet werden. Beim Tauchverfahren kommt es jedoch häufig vor, daß die Schichtdicke nicht in allen Oberflächenbereichen homogen erzeugt werden kann, sondern daß am Ende der Oberflächenteilbereiche ein Lackwulst verbleibt, der keine gleichmäßige Belichtung erlaubt. Auch beim Sprühverfahren ergibt sich ein Problem. Zwar können damit größere Flächen recht gut benetzt werden, jedoch zieht sich der Lack während des Trocknens zusammen. Dadurch ergeben sich, ähnlich wie beim Tauchverfahren, im Randbereich der Struktur Abweichungen, wodurch die Einheitlichkeit der Lackschicht gestört wird. Die Dicke der Lackwülste am Rand können bis zum Fünffachen der gewünschten Schichtdicke betragen.

Der Auftrag von Fotoresistlack auf ebenen Grundkörpern wird für fotolithografische Techniken verwendet. Diese dienen der Herstellung von Schichtstrukturen, wobei ein strahlungsempfindliches Material auf eine zu strukturierende Oberfläche aufgebracht und mit Hilfe von Masken oder lokal wirkenden Strahlschreibgeräten unter Anwendung von energetischer Strahlung bestrahlt und anschließend entwickelt wird. Auf diese Weise lassen sich Muster aus Fotoresistlack erzeugen, die als Maske für diverse Dünnschichttechnologien dienen. Die Bestrahlung des strahlungsempfindlichen Materials kann beispielsweise mittels elektromagnetischer Wellen oder Korpuskularstrahlung erfolgen.

Bei der Fotolithografie wird typischerweise ein ultraviolettes Licht im Wellenlängenbereich von etwa 430 nm bis 200 nm eingesetzt. Die fotolithografischen Verfahren finden eine breite Anwendungsmöglichkeit im Bereich der Herstellung von Halbleiterschaltungen, Sensoren oder mikrotechnischen Systemen.

Bei den bekannten Anwendungen werden als Grundkörper ebene, insbesondere makroskopisch ebene Substrate oder solche mit lediglich sehr leicht gekrümmten Oberflächen beschichtet.

Beim bekannten Schleuderverfahren wird die gewünschte Fotoresistlackdicke mit der Rotationsgeschwindigkeit der Schleuder und der Viskosität des Fotoresistlackes eingestellt. In Abhängigkeit der jeweiligen Anwendungsform werden Schichtdicken von wenigen 100 nm bis zu einigen 10 um benötigt, welche im Bereich der zu strukturierenden Oberfläche des Grundkörpers mit einer großen Homogenität aufzubringen sind. Wie bereits erwähnt, kann das Schleuderverfahren jedoch lediglich für makroskopisch ebene Oberflächen eines Grundkörpers verwendet werden.

Die sich insbesondere beim Tauchverfahren bildenden Lackwülste im Randbereich führen bei der Belichtung im Kontaktverfahren als Lackdickeninhomogenität zu einem unzulässigen Abstand zwischen der Maske und dem Substrat, welcher als "Proximity-Effekt" bezeichnet wird. Es tritt dadurch eine Beeinflussung der Qualität und der Auflösung der Fotoresiststrukturen auf, welche sich als nachteilig erweist. Ein weiterer Nachteil ist darin zu sehen, daß dieser Randbereich eine zu geringe Strahlungsdosis erfährt, aufgrund der größeren Schichtdicke und die dort vorgesehenen Muster deshalb nur ungenügend ausgebildet werden und/oder Lackreste zwischen den Mustern verbleiben.

Bei der Belackung mit dem Sprühverfahren treten die bereits genannten Strukturprobleme auf. Darüber hinaus können mit diesem Verfahren die für die Fotolithografie üblicherweise angewandten Schichtdicken von wenigen Mikrometern lediglich mit stark verdünnten Fotoresistlacken erzielt werden, was sich nachteilig auch auf die Qualität der Fotoresistlackschicht auswirkt. Diese zeigt Inhomogenitäten der Lackdicke an Ecken und Kanten. Darüber hinaus können mit dem Sprühverfahren lediglich großflächige Belackungen vorgesehen werden, was jedoch aus technischer und ökonomischer Sicht heraus, nämlich im Rahmen eines geringen Fotoresistlackverbrauches, gerade nicht wünschenswert ist. Aus diesen Erwägungen heraus wäre eher eine Belackung von definierten Teilbereichen einer Oberfläche sinnvoll. Nachteilig sowohl beim Sprüh- als auch beim Tauchverfahren ist auch der vergleichsweise sehr hohe Fotoresistlackverbrauch.

Aus der EP 0 609 478 A1 ist ein Sprühverfahren zum Beschichten von ebenen Oberflächen bekannt. Dabei werden diskrete Tropfen auf die Oberfläche aufgetragen, die dann anschließend in weiteren Verfahrensschritten wiederum eingeebnet werden. Das Verfahren ist auch nur für ebene Substrate, beispielsweise für Leiterplatten, geeignet.

Auch die DE 43 29 338 A1 zeigt ein nur flaches Substrat, bei dem ein Muster mittels einer Art Tintelstrahldruckkopf erzeugt wird.

Zum Auftragen von dickeren Fotoresistlackschichten werden im Stand der Technik Fotoresistfolien auf Grundkörper aufgebracht, wodurch bessere Homogenitäten in der Dicke zu erreichen sind. Diese Techniken sind jedoch nur für größere Schichtdicken geeignet. Zudem wird bei der Anwendung bei Grundkörpern in Form von Rotationskörpern eine Nahtstelle ausgebildet.

Aus der DE 30 12 988 A1 ist eine Vorrichtung und ein Verfahren zur Herstellung eines Druckplattenrohlings bekannt, bei dem eine Platte mit einem Träger mit einem in Form und Dicke genau bemessenen Fotopolymerstreifen versehen wird. Die Vorrichtung weist zu diesem Zweck einen Vorratsbehälter für das Fotopolymer, einen über die Platte bewegbaren Balken mit auf seiner Unterseite vorgesehenem Kanal, Zuführungen, welche den Kanal mit dem Vorratsbehälter verbinden sowie ein Abstreifmesser, welches am Balken eingeformt ist, auf. Die Fotopolymerschicht wird bei der Herstellung des Druckplattenrohlings auf den Träger aufgebracht. Anschließend wird die Fotopolymerschicht durch eine Maske mit einer chemisch aktiven Strahlung bestrahlt und nachfolgend der durch die Maske abgedeckte, unbestrahlte Bereich wieder entfernt. Das Fotopolymer wird unter Einfluß der Schwerkraft zugeführt, wobei zu diesem Zweck das Fotopolymer in dem Vorratsbehälter auf einem vorbestimmten Flüssigkeitspegel von 2,5 bis 25 cm gehalten wird. Die Viskosität des Fotopolymeres wird in der Druckschrift mit 500 bis 20.000 cP, vorzugsweise 2.000 cP angegeben. Die Fotopolymerschicht wird in einer Schichtdicke von 25 bis 510 µm aufgetragen. Die Zuführungen für das flüssige Fotopolymer sind als Kapillarkanäle in Einformung in dem Balken ausgeführt. Die einzelnen Zuführungen weisen dabei einen Durchmesser von 0,76 bis 12,7 mm, insbesondere 2,28 bis 6,35 mm auf. Die einzelnen Austrittsöffnungen bzw. Zuführungen weisen einen Mittenabstand von 3,18 bis 25,4 mm, insbesondere 6,35 bis 12,7 mm auf. Dadurch wird beispielsweise in einem Zug auf dem Träger der ebenen Platte des Druckplattenrohlings ein Polymerstreifen von etwa 40 cm Breite und etwa 60 cm Länge hergestellt.

Der Erfindung liegt die Aufgabe zugrunde, eine Vorrichtung und ein Verfahren zum Auftragen von Fotoresistlack auch auf nicht ebene Oberflächen eines beliebig geformten Grundkörpers, insbesondere Rotationskörpers, zu schaffen, wobei eine definierte, homogene, gleichmäßig dünne und zuverlässige Lackschicht auf der Oberfläche des Bauteils aufgetragen werden kann.

Die Aufgabe wird durch eine Vorrichtung zum Auftragen von Fotoresistlack auf Oberflächen eines Grundkörpers gelöst, mit einer Aufnahmeeinrichtung für den Grundkörper mit einer relativ dazu bewegbaren Zuführungseinrichtung für den Fotoresistlack und mit Mitteln zum definierten Bewegen des Grundkörpers, wobei die Zuführungseinrichtung zumindest ein Punktquellmittel aufweist und bei der zum punktuellen begrenzten Aufbringen des Fotoresistlackes das Punktquellmittel eine konisch geformte Spitze aufweist.

Insbesondere ist vorgesehen, daß die konisch geformte Spitze als konisch zulaufenden Faserbündel oder ein mit einer konisch zulaufenden Spitze versehenes Kapillarsystem ausgebildet ist.

Die Aufgabe wird auch durch ein Verfahren zum Auftragen von Fotoresistlack auf einer Oberfläche eines Grundkörpers gelöst, wobei die mit dem Lack zu versehende Oberfläche des Grundkörpers und eine Zufuhreinrichtung für den Fotoresistlack vorbestimmbar oder vorbestimmt relativ zueinander bewegt werden, wobei die Schichtdicke des Fotoresistlackes auf der Oberfläche des Grundkörpers durch Variation der Verschiebegeschwindigkeit der Zuführungseinrichtung für den Fotoresistlack und/oder der Durchlässigkeit eines oder mehrerer Punktquellmittel der Zufuhreinrichtung und/oder der Rotationsgeschwindigkeit des Grundkörpers eingestellt wird und der Fotoresistlack punktuell definiert aufgetragen wird, wobei der Transport des Fotoresistlackes aus dem Punktquellmittel auf die zu belackende Oberfläche des Grundkörpers aufgrund von Schwerkraft oder durch eine Druckregelung der Zufuhr des Fotoresistlackes aus einer Vorratskammer erfolgt und die Abgabe des Fotoresistlackes aus einer konisch geformten Spitze des Punktquellmittels erfolgt.

Weiterbildungen der Erfindung sind in den jeweiligen Unteransprüchen definiert.

Dadurch werden eine Vorrichtung und ein Verfahren zum Auftragen von Fotoresistlack geschaffen, mittels derer beliebig geformte Grundkörper mit einer besonders dünnen Lackschicht gleichmäßig versehen werden können. Es entstehen nicht mehr die nachteiligen Lackwülste am jeweiligen Rand oder Ende der dreidimensionalen Körper, wie dies beim Stand der Technik ansonsten üblicherweise auftritt. Es lassen sich die unterschiedlichsten dreidimensionalen Strukturen belacken, insbesondere auch Maschinenkomponenten, Werkzeuge und Bauteile verschiedenster Art sowie ebenfalls Spektralfotometer bzw. andere optische Geräte, um Linsengeometrien und dergleichen zu erzeugen. Dabei lassen sich auch unterschiedliche Lackdicken auf dem jeweiligen Grundkörper aufbringen, wodurch sehr vorteilhaft auch stufenweise Masken geschaffen werden können. Eine Anwendung hierfür besteht insbesondere bei den optischen Geräten, bei denen Gradienten in der Lackdicke benötigt werden. In der Mikrooptik taucht ansonsten oftmals auch das Problem unterschiedlicher Ätzraten des Fotoresistlackes und des Materials, auf das er aufgebracht werden soll, auf. Diese Probleme werden jedoch vorteilhaft mittels des erfindungsgemäßen Verfahrens bzw. mit Hilfe der erfindungsgemäßen Vorrichtung gelöst. Erfindungsgemäß können nämlich sogar stark strukturierte Oberflächen, die ansonsten mit dem Verfahren des Standes der Technik nicht zugänglich sind, bedient werden. Sogar Mikroporen können mit einer entsprechenden Fotoresistlackschicht versehen werden. Besonders vorteilhaft erweist es sich, daß auch lediglich eine Lackspur gelegt werden kann und insbesondere kleine Gebiete bzw. lokal Fotoresistlack aufgetragen werden kann. Dadurch lassen sich nicht nur beliebige Formen aus dem Fotoresistlack erzeugen, sondern es werden auch Kosten gespart, da der Fotoresistlack lediglich an den Stellen aufgetragen wird, an denen er auch benötigt wird. Die Kosten für Fotoresistlack sind ansonsten, insbesondere bei der großflächig deckenden Auftragung mittels der Verfahren des Standes der Technik, sehr hoch.

Erfindungsgemäß können im Verhältnis zu den Lackdicken gemäß der DE 30 12 988 A 1 sehr dünne Lackschichtdicken von bis zu etwa 10 µm erzeugt werden. Die gerade in der Halbleiterbeschichtung erforderlichen sehr dünnen Lackschichtdicken von beispielsweise 1 bis 2 µm lassen sich mit dem erfindungsgemäßen Verfahren und der erfindungsgemäßen Vorrichtung daher sehr leicht herstellen. Diese dünne Lackschichtdicke ist in insbesondere sehr präziser Ausfertigung, also gleichmäßiger Belegung auf der gesamten Oberfläche des Rotationskörpers besonders wichtig, da lediglich eine Belichtungszeit von wenigen Sekunden vorgenommen wird. Schon eine minimale Schichtdicke von 25 pm liegt deutlich oberhalb der für Dünnschichtanwendungen erforderlichen Fotoresistdicke. Ein solches, in der DE 30 12 988 A1 beschriebenes Verfahren ist zur Herstellung von homogenen Schichten mit Dicken von 0,1 bis 3 µm, insbesondere verwendet für Schichtstrukturierungen, völlig ungeeignet, insbesondere auch, da tolerierbare Streuungen der Fotoresistdicke lediglich im Bereich bis zu 10 % liegen dürfen. Bei einer einheitlichen Bestrahlungsdosis werden ansonsten dicke Lackschichten nicht durchentwickelt oder aber bei einer Überdosierung der UV-Strahlung (ultra violette Strahlung) die Strukturabmessung lokal starken Schwankungen unterworfen. Besonders vorteilhaft ist es mit der erfindungsgemäßen Vorrichtung und mit dem erfindungsgemäßen Verfahren möglich, eine lokal begrenzte Belackung im Bereich von insbesondere wenigen 100 µm² vorzusehen. Eine besonders bevorzugte technische Anwendung liegt hier im Bereich der Sensorik. Dabei ist eine besonders präzise Belackung sehr relevant. Mittels der Verfahren des Standes der Technik ist lediglich eine Belackung einer Mindestfläche von mehreren 100 cm² möglich, wobei eine lokale Variation der Fotoresistschichtdicke zur Ausgestaltung seiner geometrischen Struktur nicht möglich ist.

Eine besonders bevorzugte Anwendungsform liegt auch im Bereich der Mikrooptik oder Mikrosystemtechnik. Als besonders vorteilhaft erweist sich auch die Nutzung auf Maschinenbauteilen, insbesondere auf einer Achse mit integrierten und direkt aufgebrachten Dünnschichtsensoren. Dabei wird die zur Strukturierung erforderliche Fotoresistlackmaske lokal mittels des erfindungsgemäßen Verfahrens aufgebracht.

Als besonders vorteilhaft erweist sich auch neben der Einsparung der Kosten für den Fotoresistlack die geringere Umweltbelastung aufgrund der nicht anfallenden oder im wesentlichen nicht anfallenden zu entsorgenden Fotoresistlackverluste, welche sonst beim Sprühverfahren oder beim Schleuderverfahren in grossen Mengen auftreten.

Als besonders vorteilhaft erweist es sich, daß bei der Belackung von insbesondere beschichteten Maschinenbauteilen, bei denen die Beschichtung eine geringe Oberflächenenergie aufweist, die erfindungsgemäß aufgebrachte Fotoresistschicht mit einer Dicke von beispielsweise 2,2 um eine deutlich bessere Haftung auf der Oberfläche des Maschinenbauteils bzw. des entsprechenden Substrates auf dessen Oberfläche zeigt, als dies mit einer Belackung im Tauchverfahren nach dem Stand der Technik möglich ist. Die Maschinenbauteile können hier beispielsweise Zylinder, Achsen, Lagerschalen, Rundstäbe oder Werkzeuge beliebiger Ausführungsformen sein.

Unter den Punktquellmitteln der Zuführungseinrichtung werden Zuführungsmittel oder Quellmittel für den Fotoresistlack verstanden, die eine punktförmige Aufbringung des Fotoresistlackes in besonders kleinen Dosierungen auf die Oberfläche des Grundkörpers ermöglichen. Bevorzugt werden dabei entweder Glasfaser- oder Faserkörper oder Stifte mit entsprechend geformter Spitzengeometrie oder Kapillarröhrchen mit entsprechend geformter Spitzengeometrie oder düsenartige Mittel, insbesondere in Verbindung mit einer Impulsdruckeinrichtung, verwendet. Die Punktquellmittel können in einer besonders bevorzugten Ausführungsform als sogenanntes Array, also mehrere einzelne Mittel vor- und nebeneinander vorgesehen sein. Abhängig von der jeweiligen Ausführungsform der Punktquellmittel kann der Fotoresistlackauftrag durch Kontakt des Punktquellmittels mit der Oberfläche des Grundkörpers erfolgen oder aber durch auf die Oberfläche des Grundkörpers aufgebrachte Fotoresistlacktropfen, wobei dann die bzw. das Punktquellmittel in einem definierten Abstand zu der Oberfläche des Grundkörpers angeordnet ist. Bei Vorsehen eines sogenannten Arrays von Punktquellmitteln können die einzelnen Mittel in vorbestimmter Reihenfolge von der Oberfläche abhebbar sein, also schaltbar sein, wodurch dann definiert nur an bestimmten Stellen ein Fotoresistlackauftrag erfolgt.

Vorzugsweise wird ein Abstandssensor vorgesehen, der die Zuführungseinrichtung mit dem oder den Punktquellmitteln in einem konstanten, vorbestimmten Abstand zur Oberfläche des Grundkörpers nachführt. Dadurch können vorteilhaft auch beliebig geformte Oberflächen eines Rotationskörpers bzw. eines rotierbaren Grundkörpers präzise mit einer definierten Lackschichtdicke versehen werden.

Besonders bevorzugt werden für den Vorschub der Zuführungseinrichtung mit dem oder den Punktquellmitteln Schrittmotoren eingesetzt. Anwendungsspezifisch können diese auch kleinste Vorschübe, insbesondere auch eine Bewegung in unterschiedliche Richtungen vollführen. Durch ensprechende Auslegung von Vorschub der Zuführungseinrichtung und Rotationsgeschwindigkeit des Grundkörpers in der Vorrichtung sind vorteilhaft große Freiheitsgrade für den Auftrag der Fotoresistlackschicht auf der Oberfläche des Grundkörpers gegeben.

Besonders bevorzugt wirkt eine Impulsdruckeinrichtung bei einem düsenförmigen Punktquellmittel mit einem Aktor-, insbesondere Piezoaktuatorsystem zusammen. Die düsenförmigen oder das düsenförmige Punktquellmittel stehen bevorzugt über entsprechend dimensionierte Verbindungselemente mit der Vorratskammer für den Fotoresistlack in Verbindung. Die Vorratskammer kann dabei an einer beliebigen Stelle angeordnet werden, da die Impulsdruckeinrichtung von sich aus den Fotoresistlack zu den düsenförmigen Punktquellmitteln transportiert. Werden hingegen die düsenförmigen Punktquellmittel über Schwerkraft mit dem Fotoresistlack beaufschlagt, wird eine Anordnung der Vorratskammer für den Fotoresistlack oberhalb der düsenförmigen Punktquellmittel bevorzugt.

Besonders bevorzugt ist die definierte Spitzengeometrie der Punktquellmittel konisch geformt und weist insbesondere einen Krümmungsradius im Bereich von 1 um bis 100 pm auf.

Bei Vorsehen einer Impulsdruckeinrichtung für das Punktquellmittel kann zur definierten Fotoresistlackzufuhr eine Druckregelung im Bereich der Vorratskammer für den Fotoresistlack vorgesehen werden.

Bei der Aufbringung von Fotoresistlacken unterschiedlicher Viskositäten und Zusammensetzungen oder bei der Aufbringung von Primern oder anderen Haftvermittlern wird besonders bevorzugt eine Steuerung des Vorganges dahingehend vorgesehen, daß eine zusammenhängende Schicht aus Fotoresistlack in einem definierten Teilbereich des Grundkörpers entsteht. Darüber hinaus wird der Auftrag von Fotoresistlack besonders bevorzugt in einer Kammer mit gesättigtem Lösungsmitteldampf durchgeführt, wobei darin insbesondere der Grundkörper und die Zuführungseinrichtung für den Fotoresistlack, also Teile der Vorrichtung, angeordnet sind.

Zur näheren Erläuterung der Erfindung werden im folgenden Ausführungsbeispiele anhand der Zeichnungen beschrieben.

Diese zeigen in:
- **Figur 1**: eine schematische Ansicht des prinzipiellen Aufbaus einer erfindungsgemäßen Vorrichtung,
- **Figur 2**: eine Seiten- bzw. Schnittansicht durch eine erste Ausführungsform eines erfindungsgemäßen Punktquellmittels,
- **Figur 3**: eine Seitenansicht einer teilbelackten Zylinderoberfläche,
- **Figur 4**: eine Schnittansicht durch ein Substrat mit Fotoresistlackprofilen,
- **Figur 5**: eine Schnittansicht durch ein anderes Substrat mit Fotoresistlackprofil,
- **Figur 6**: eine Seitenansicht einer Zahnradachse mit Zahnrad und auf der Achsoberfläche erfindungsgemäß aufgetragenen Dünnschichtsensoren,
- **Figur 7**: eine Seitenansicht einer alternativen Ausführungsform des Punktquellmittels,
- **Figur 8**: eine Schnittansicht von mehreren reihenförmig nebeneinander angeordneten Punktquellmitteln, und
- **Figur 9**: eine Untersicht auf ein Array von Punktquellmitteln.

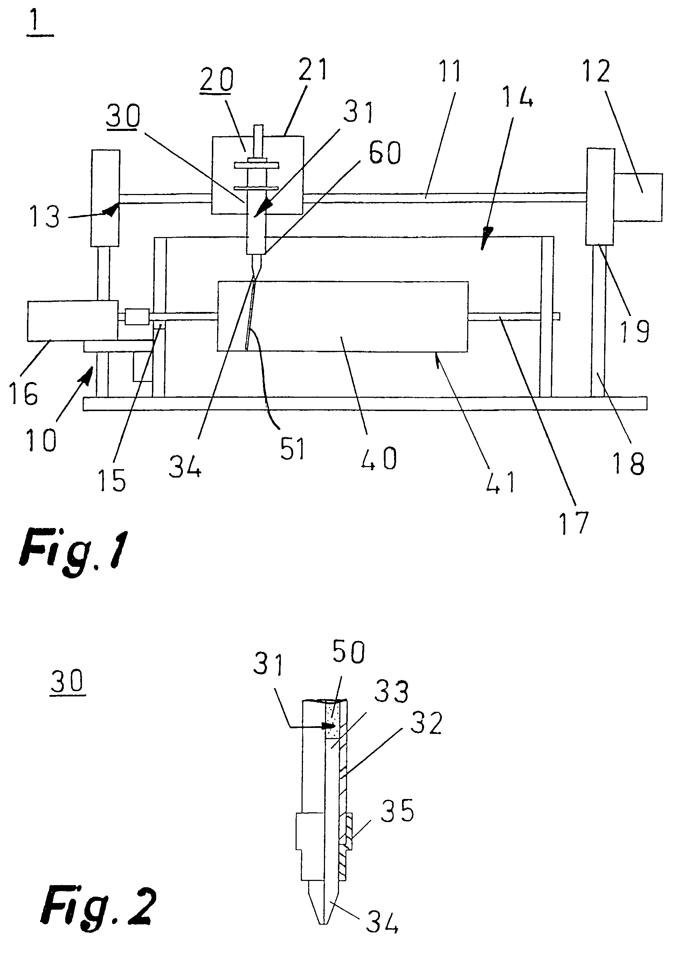

In **Figur 1** ist eine schematische Ansicht des Aufbaus einer erfindungsgemäßen Vorrichtung 1 zum Auftragen von Fotoresistlack schematisch dargestellt. Die Vorrichtung weist ein Gestell 10 auf. Auf dem Gestell sind, gestützt auf entsprechende Halterungselemente, die Verschiebeeinrichtungen bzw. Rotationseinrichtungen zum Schaffen einer Relativbewegung zwischen einem Grundkörper 40 und einer Zuführeinrichtung 20 für Fotoresistlack dargestellt. Die Zuführeinrichtung 20 für den Fotoresistlack weist ein verschiebbares Gehäuse 21 auf. Das Gehäuse 21 ist entlang einer x-z-Verschiebeinrichtung 11 in x-z-Richtung verschiebbar. Die Verschiebeeinrichtung 11 kann beispielsweise eine Spindel sein. Diese ist auf den Halterungselementen 18 mittels einer Lagerung 13 gelagert. Die Verschiebeeinrichtung 11 wird durch ein motorisches Antriebsmittel 12 angetrieben. Dies kann vorzugsweise ein Schrittmotor sein. Dadurch können auch geringe Vorschübe erzielt werden. Durch eine Änderung innerhalb der Halterungselemente 18 bzw. der Lagerung 13 der Verschiebeeinrichtung 11 kann auch eine Änderung in y-Richtung erfolgen, wodurch die Zuführeinrichtung 20 in allen drei Raumkomponenten bewegbar wird.

Der Grundkörper 40 ist in einer Aufnahmeeinrichtung 14 angeordnet. Beidseitig wird er, hier in der Ausführungsform eines Zylinders, von Einspannmitteln 17 gehalten. Die Einspannmittel 17 sind in einer Lagerung 15 der Aufnahmeeinrichtung 14 rotierbar gelagert. Zum Rotieren des Grundkörpers ist ein Antriebsmittel 16 an das eine Einspannmittel 17 außerhalb der Lagerung 15 der Aufnahmeeinrichtung 14 angekoppelt.

Vorzugsweise sind beide Antriebsmittel 12 und 16 motorisch und regelbar. Dadurch kann eine optimale Anpassung an den jeweiligen Grundkörper und die jeweilig aufzufügende Beschichtungsfläche bzw. Beschichtungsart und -dicke mit dem Fotoresistlack erfolgen.

Das Gehäuse 21 der Zuführeinrichtung 20 bewegt sich auf der Verschiebeeinrichtung 11 in Form eines Schlittens. Während der Bewegung wird aus einem Punktquellmittel 30 der Zuführeinrichtung 20 Fotoresistlack auf den Grundkörper 40 an den gewünschten Stellen in Form einer Spur 51 aufgetragen. Das hier dargestellte Punktquellmittel 30 steht mit der Oberfläche 41 des Grundkörpers 40 in Kontakt. In einer alternativen Ausführungsform ist es aber auch möglich, daß zwischen der Oberfläche 41 des Grundkörpers 40 und der Austrittsöffnung aus der Spitze 34 des Punktquellmittels 30 ein Abstand, vorzugsweise ein definierter Abstand besteht. Um diesen definierten Abstand aufrechtzuerhalten, erweist es sich als besonders vorteilhaft, ein sensorisches Mittel 60 zum Überprüfen des jeweiligen Abstandes vorzusehen. In der Ausführungsform gemäß Figur 1 ist ein solches Abstandssensormittel 60 beispielhaft an dem Punktquellmittel 30 angeordnet. Es kann aber auch an der Zuführeinrichtung 20 bzw. deren Gehäuse 21 an einer beliebigen Stelle angeordnet sein.

Das Punktquellmittel 30 weist ein Vorratsbehältnis 31 auf, in welchem der Fotoresistlack vorgehalten wird.

Eine erste Ausführungsform eines erfindungsgemäßen Punktquellmittels 30 ist besser **Figur 2** zu entnehmen. Die dort dargestellte Ausführungsform des Punktquellmittels 30 weist im oberen Bereich das Vorratsbehältnis 31 für den Fotoresistlack 50 auf. Das Vorratsbehältnis 31 ist ummantelt von einem Röhrchen 32. Besonders bevorzugt ist die Wandung des Röhrchens 32 zugleich die äußere Wandung des Vorratsbehältnisses 31.

Unterhalb des Vorratsbehältnisses 31 im Röhrchen 32 ist ein Faserbündel 33 angeordnet. Dieses ist beispielsweise ein Glasfaserbündel. Es weist eine konisch geformte Spitze 34 auf. Diese ragt über die untere Erstreckung des Röhrchens 32 hinaus. Zum rutschfesten Verbinden von Röhrchen 32 und Faserbündel 33 ist ein Schrumpfschlauch 35 im Übergangsbereich zwischen Röhrchenende und überstehendem Faserbündel aufgeschrumpft. Dadurch besteht auch nicht die Gefahr, daß beim Kontakt mit der Oberfläche 41 des Grundkörpers 40 das Faserbündel 33 bereits durch geringen Kontakt nach innen in das Röhrchen 32 hineingeschoben wird. Ein solcher Effekt ist sonst von normalen Fasermalstiften bekannt. Das Röhrchen 32 ist vorzugsweise aus Glas vorgesehen.

Der Fotoresistlack 50 gelangt zur Spitze 34 des Faserbündels 33 durch Wirken von Schwerkraft, wobei sich das Faserbündel 33 mit dem Lack 50 vollsaugt. Es ist daher nicht notwendig, ein zusätzliches Pumpmittel oder Druckmittel zum Befördern des Fotoresistlackes aus dem Punktquellmittel heraus auf den Grundkörper vorzusehen. Jedoch kann dies dennoch bei einer alternativen Ausführungsform vorgesehen sein, insbesondere zur Beschleunigung des Austritts des Lackes aus dem Punktquellmittel.

Der Auftragvorgang für den Fotoresistlack 50 erfolgt dadurch, daß die Zuführeinrichtung 20 durch das motorische Antriebsmittel 12 definiert in x-z-Richtung verstellt wird. Dies geschieht insbesondere kontinuierlich. Während dieser Verstellung bzw. Positionierung tritt der Fotoresistlack aus der Spitze 34 des Punktquellmittels 30 aus. Dies geschieht vorzugsweise ebenfalls kontinuierlich, insbesondere durch Kontakt mit der Oberfläche 41 mit dem Grundkörper 40. Bei Abheben des Punktquellmittels 30, gesteuert durch die x-y-Positioniereinrichtung 19 in dem Halterungselement 18 kann dann automatisch die Fotoresistlackzufuhr gestoppt werden. Die Spur 51 auf der Oberfläche 41 des Grundkörpers 40 wird dadurch unterbrochen.

Die Dicke der Fotoresistschicht wird bei deren gegebener Viskosität mittels der Relativbewegung und -geschwindigkeit zwischen der x-z-Verschiebebewegung der Zuführeinrichtung 20 und der Rotationsgeschwindigkeit, gesteuert und geregelt durch das Antriebsmittel 16, des Grundkörpers 40 eingestellt. Vorzugsweise ist dabei zumindest das motorische Antriebsmittel 12 computergesteuert. Dadurch kann vorteilhaft der Grundkörper bzw. auch ein darauf vorgesehenes Substrat mit dem Grundkörper zusammen in Rotation und in einer oszillierenden Bewegung relativ zum Punktquellmittel bewegt werden. Auf diese Weise können ganzflächige Belackungen der Oberfläche 41 des Grundkörpers 40 erzielt werden. Ebenso können damit aber auch, insbesondere durch eine wechselweise Hin- und Rückbewegung eine Belackung in Teilfelder oder in einem kleinen, begrenzten Gebiet erfolgen. Die Belackung wird dadurch lokal oder linienförmig begrenzt und homogen aufgetragen. Die entsprechende Ansteuerung erfolgt vorzugsweise ebenfalls über einen Computer.

Vermittels der in Figur 1 dargestellten Vorrichtung können auch beispielsweise gradierte Bewegungsabläufe vorgenommen werden, durch die eine gezielte lokale Variation der Schichtdicke des Fotoresistlackes erzeugt werden kann.

Dadurch können Stufenmuster in der Maske des Fotoresistlackes hergestellt werden, welche durch Anwendung entsprechender Belichtungs- und Ätzverfahren zur Herstellung von dreidimensionalen mikrotechnischen Bauteilen genutzt werden können.

Als Fotoresistlack wird beispielsweise ein entsprechender Lack der Firma Hoechst, welcher dort unter der Bezeichnung AZ 6615 vertrieben wird, verwendet.

Soll beispielsweise auf einen Zylinder eine 2,3 um dicke Fotoresistlackschicht aufgetragen werden, geschieht dies z.B. im Kontaktverfahren. Der Zylinder wird als Grundkörper mittels des Antriebsmittels 16 konstant rotiert, wobei die Zuführungseinrichtung 20 durch das motorische Antriebsmittel 12 in Verbindung mit der Verschiebeeinrichtung 11 ebenfalls konstant gegenüber der zu belackenden Oberfläche 41 bzw. Mantelfläche des Zylinders verschoben wird. Auf der Mantelfläche entsteht dadurch eine Schraubenlinie. Diese wird so eng gestaltet, daß durch die Strichdicke die benachbarten Linien des Fotoresistlackes ineinander verlaufen. Die Viskosität des Fotoresistlackes entspricht vorzugsweise der vom Hersteller vorgegebenen Lieferviskosität von insbesondere 21 cSt (bzw. ebenso angebbar in mm²/sek. bei 25°C). Außer der Abhängigkeit der Schichtdicke des Fotoresistlackes auf der Mantelfläche des Zylinders von der Relativbewegung von Zuführeinrichtung und Zylinder zueinander ist diese auch abhängig von der Durchlässigkeit des Faserbündels und dem Vordruck, insbesondere in Form eines Glasfaserbündels, besonders im Bereich von dessen Spitze 34. Durch gezielte Veränderung dieser Parameter kann auf einfache Weise die Schichtdicke des Fotoresistlackes gezielt variiert werden.

Die zu erzielenden Schichtdicken des Fotoresistlackes können zwischen 0,2 bis 50 µm variiert werden bei einer Genauigkeit von weniger als 3 %. Beispielsweise kann eine Schichtdicke von 2,2 um mit dem genannten Fotoresistlack bei einer Vorschubgeschwindigkeit der Zuführungseinrichtung von 1,2 mm/sec. und einer Rotationsgeschwindigkeit des Grundkörpers von 0,08 Umdrehungen/sec. hergestellt werden.

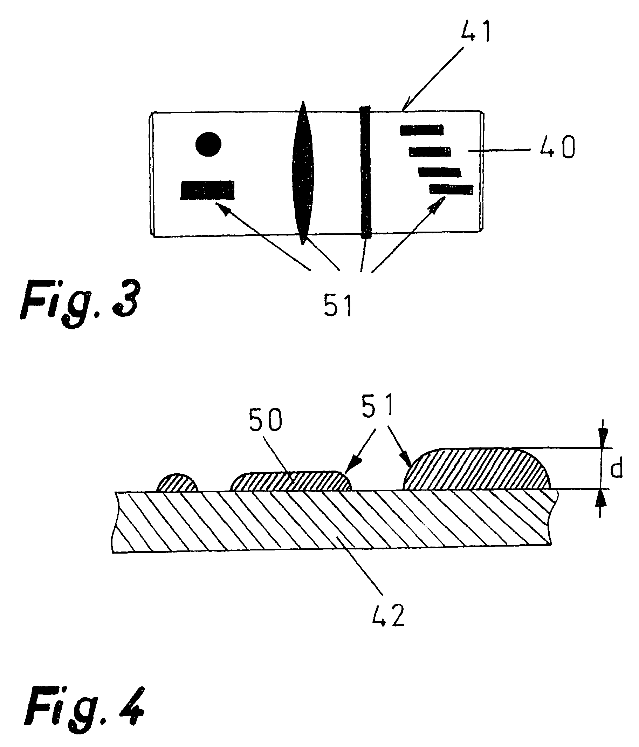

**Figur 3** zeigt einen zylinderförmigen Grundkörper 40, dessen Oberfläche 41 teilbelackt ist. Hierbei ist deutlich erkennbar, daß mittels des erfindungsgemäßen Verfahrens sowohl streifenförmige als auch punktförmige, insbesondere rechteckförmige Spuren auf der Oberfläche des Zylinders gelegt werden können. Das Beschichtungsverfahren eignet sich daher u.a. auch für die Druckindustrie zum Herstellen von Druckwalzenrohlingen etc.

In **Figur 4** ist ein entsprechendes Substrat 42 in der Querschnittsansicht dargestellt. Das Substrat 42 ist mit Spuren 51 aus Fotoresistlack 50 versehen. Die einzelnen Spuren zeigen jeweils unterschiedliche Profile. Die entsprechende Dicke d des Fotoresistlackes variiert hierbei und ist dadurch einzustellen, daß die Relativbewegung von Substrat 42 und Punktquellmittel 30 sowie die Vordrucksteuerung des Fotoresistlackes aus dem entsprechenden Vorratsbehältnis heraus eingestellt wird.

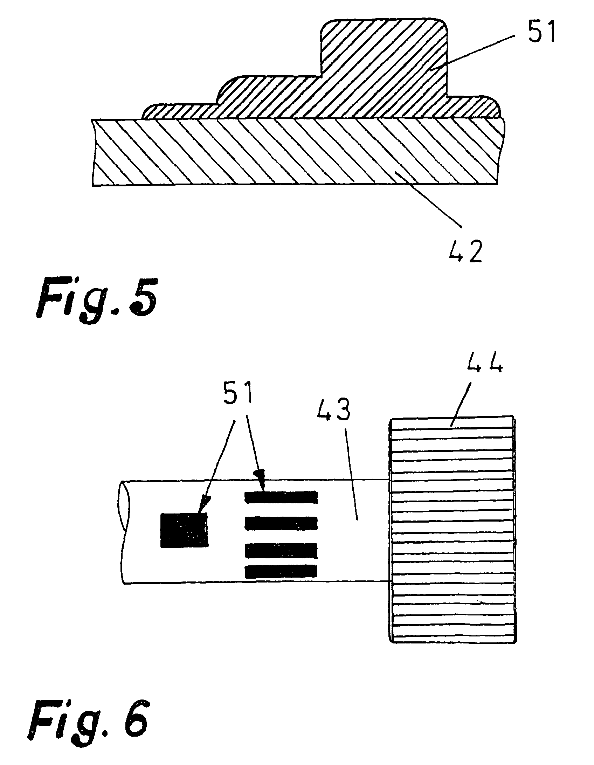

Eine entsprechend andere Ausführungsform des Fotoresistlackprofiles auf der Substratoberfläche ist in **Figur 5** dargestellt. Dabei sind unterschiedliche Abstufungen von Resistlackdicken vorgesehen, wodurch auf der Oberfläche des Substrates eine stufenförmige Maske aufgefügt wird.

**Figur 6** zeigt eine Draufsicht auf eine Zahnradachse 43 eines Zahnrades 44, welche teilbelackt ist. Diese Teilbelackung mit dem Fotoresistlack kann zur Herstellung von Dünnschichtsensoren auf der Oberfläche dieser Zahnradachse 43 genutzt werden. Derartige Dünnschichtsensoren werden beispielsweise zur ständigen Überwachung des ordnungsgemäßen Zustandes der Zahnradachse 43 verwendet.

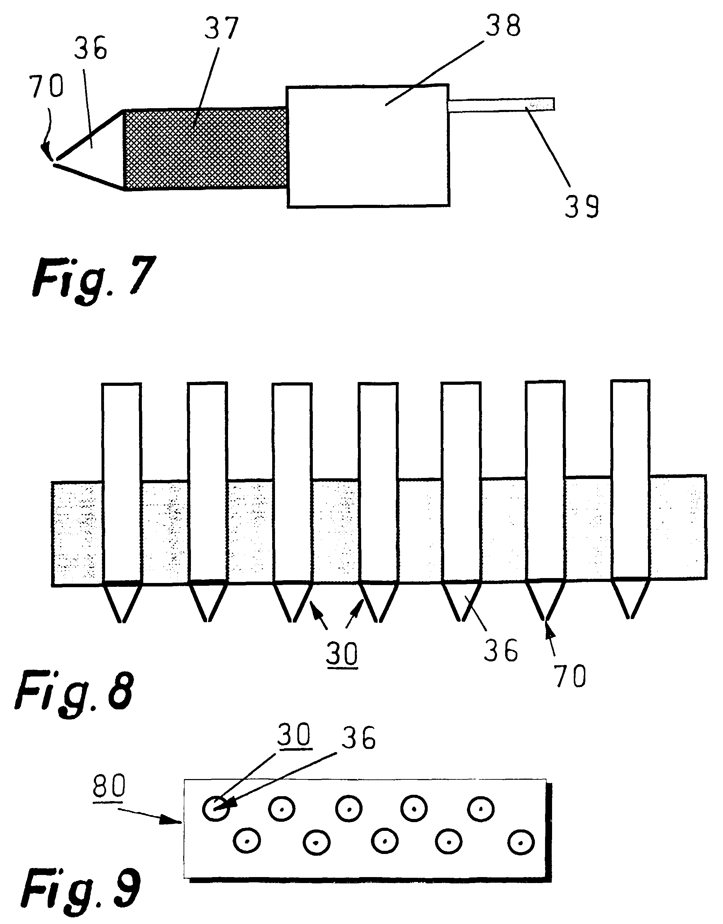

**Figur 7** zeigt eine Seitenansicht des prinzipiellen Aufbaus eines Punktquellmittels in Form einer Impulsdruckeinrichtung. Diese weist ein Düsenteil 36 als vordere Spitze mit Austrittsöffnung 70 auf. Dahinter ist eine Piezoaktoreinrichtung 37 vorgesehen, welche mit einer Vorratskammer 38 für Fotoresistlack verbunden ist. Letztere ist über ein Verbindungselement 39 an ein zentral vorgesehenes Fotoresistvorratsbehältnis angeschlossen und wird von diesem mit Fotoresistlack gespeist.

In **Figur 8** ist eine Schnittansicht von mehreren reihenartig nebeneinander angeordneten und gehalterten Punktquellmitteln 30 skizziert. Die Punktquellmittel sind insbesondere Impulsdruckeinrichtungen. Sie bilden eine Reihe für die Belackung einer nicht ebenen Oberfläche eines Grundkörpers mit einer breiten Spur.

**Figur 9** zeigt eine Ausführungsform von mehreren flächig, versetzt zueinander angeordneten Punktquellmitteln in der Untersicht. Die Punktquellmittel bilden dabei ein sog. Array 80 zur Belackung mit einer breiten Spur. Die Punktquellmittel können düsen- oder stiftförmig sowie ansteuerbar, insbesondere getrennt ansteuerbar sein.

### Bezugszeichenliste

- 1: Vorrichtung
- 10: Gestell
- 11: x-z-Verschiebeeinrichtung / Spindel
- 12: motorisches Antriebsmittel
- 13: Lagerung
- 14: Aufnahmeeinrichtung
- 15: Lagerung
- 16: Antriebsmittel
- 17: Einspannmittel, rotierbar
- 18: Halterungselemente
- 19: x-y-Positioniereinrichtung
- 20: Zuführeinrichtung
- 21: Gehäuse, verschiebbar / Schlitten
- 30: Punktquellmittel
- 31: Vorratsbehältnis
- 32: Röhrchen
- 33: Faserbündel
- 34: Spitze, konisch geformt
- 35: Schrumpfschlauch
- 36: Düsenteil
- 37: Piezoaktoreinrichtung
- 38: Vorratskammer
- 39: Verbindungselement
- 40: Grundkörper
- 41: Oberfläche
- 42: Substrat
- 43: Zahnradachse
- 44: Zahnrad
- 50: Fotoresistlack
- 51: Spur
- 60: Abstandssensormittel
- 70: Austrittsöffnung
- 80: Array
- d: Resistlackdicke

## Patentansprüche

1. Vorrichtung zum Auftragen von Fotoresistlack auf Oberflächen eines Grundkörpers mit einer Aufnahmeeinrichtung (14) für den Grundkörper (40), mit einer relativ dazu bewegbaren Zuführungseinrichtung (20) für den Fotoresistlack (50) und mit Mitteln (16) zum definierten Bewegen des Grundkörpers, wobei die Zuführungseinrichtung (20) zumindest ein Punktquellmittel (30) aufweist,
**dadurch gekennzeichnet**,
daß zum punktuellen begrenzten Aufbringen des Fotoresistlackes (50) das Punktquellmittel (30) eine konisch geformte Spitze (34) aufweist.

2. Vorrichtung nach Anspruch 1,
**dadurch gekennzeichnet**,
daß die konisch geformte Spitze als ein konisch zulaufendes Faserbündel oder ein mit einer konisch zulaufenden Spitze versehenes Kapillarsystem ausgebildet ist.

3. Vorrichtung nach Anspruch 1 oder 2,
**dadurch gekennzeichnet**,
daß das Punktquellmittel (30) eine Impulsdruckeinrichtung aufweist.

4. Vorrichtung nach einem der vorstehenden Absprüche,
**dadurch gekennzeichnet**,
daß die konisch geformte Spitze einen Krümmungsradius von 1 µm bis 100 µm aufweist.

5. Vorrichtung nach einem der vorstehenden Ansprüche,
**dadurch gekennzeichnet**,
daß das Punktquellmittel (30) ein Röhrchen (32) mit Vorratsbehältnis (31) für Fotoresistlack (50), in Verbindung damit ein Faserbündel (33) mit konisch geformter Spitze (34) und einen das Faserbündel und das Röhrchen verbindenden Schrumpfschlauch (35) aufweist.

6. Vorrichtung nach einem der Ansprüche 3 oder 4,
**dadurch gekennzeichnet**,
daß die Impulsdruckeinrichtung düsenförmige Elemente oder ein düsenförmiges Element (36), ein Aktorsystem (37), eine Vorratskammer (38) und/oder ein Vorratsbehältnis für Fotoresistlack sowie Verbindungselemente (39) zum Verbinden von düsenförmigen Elementen und Vorratsbehältnis aufweist.

7. Vorrichtung nach einem der vorstehenden Ansprüche,
**dadurch gekennzeichnet**,
daß Punktquellmittel (30) ein schaltbares Düsen- und/oder Stiftarray (80) ist.

8. Vorrichtung nach Anspruch 7,
**dadurch gekennzeichnet**,
daß das schaltbare Düsen- und/oder Stiftarray (80) in Form von mehreren getrennt ansteuerbaren Düsen oder Stiften als Mikrosystem ausgebildet ist.

9. Verfahren zum Auftragen von Fotoresistlack auf einer Oberfläche eines Grundkörpers, insbesondere vermittels einer Vorrichtung nach einem der Ansprüche 1 bis 8,
wobei die mit dem Lack zu versehende Oberfläche(41) des Grundkörpers (40) und eine Zufuhreinrichtung (20) für den Fotoresistlack (50) vorbestimmbar oder vorbestimmt relativ zueinander bewegt werden, wobei die Schichtdicke des Fotoresistlackes auf der Oberfläche des Grundkörpers durch Variation der Verschiebegeschwindigkeit der Zuführungseinrichtung für den Fotoresistlack und/oder der Durchlässigkeit eines oder mehrerer Punktquellmittel (30) der Zufuhreinrichtung (20) und/oder der Rotationsgeschwindigkeit des Grundkörpers eingestellt wird und der Fotoresistlack punktuell definiert aufgetragen wird, wobei der Transport des Fotoresistlackes aus dem Punktquellmittel auf die zu belackende Oberfläche des Grundkörpers aufgrund von Schwerkraft oder durch eine Druckregelung der Zufuhr des Fotoresistlackes aus einer Vorratskammer erfolgt und die Abgabe des Fotoresistlackes aus einer konisch geformten Spitze (34) des Punktquellenmittels erfolgt.

10. Vorrichtung nach Anspruch 9,
**dadurch gekennzeichnet,**
daß der Fotoresistlack (50) über konisch zulaufende Faserbündel oder ein mit einer konisch zulaufende Spitze versehenes Kapillarsystem geführt wird.

11. Verfahren nach Anspruch 9 oder 10,
**dadurch gekennzeichnet**,
daß die Aufbringung von Fotoresistlacken unterschiedlicher Viskositäten und Zusammensetzungen und/oder die Aufbringung von Primern oder anderen Haftvermittlern so gesteuert wird, daß eine zusammenhängende Schicht in einem definierten Bereich oder auf der gesamten Oberfläche des Grundkörpers entsteht.

12. Verfahren nach einem der Ansprüche 9 bis 11,
**dadurch gekennzeichnet**,
daß der Auftrag von Fotoresistlack in einer Kammer mit gesättigtem Lösemitteldampf betrieben wird, wobei Teile der Vorrichtung in dieser Kammer angeordnet sind, insbesondere der Grundkörper (40) und die Zufuhreinrichtung (20) für den Fotoresistlack (50).

13. Verfahren nach einem der Ansprüche 9 bis 12,
**dadurch gekennzeichnet**,
daß auf der Oberfläche des Grundkörpers unterschiedliche Lackschichtdicken und/oder der Fotoresistlack in Teilfelder oder in einem kleinen, begrenzten Gebiet lokal oder linienförmig begrenzt homogen aufgetragen wird.

14. Verfahren nach einem der Ansprüche 9 bis 13,
**dadurch gekennzeichnet**,
daß der Fotoresistlack tropfenförmig aus einer Distanz zur Oberfläche des Grundkörpers auf diese und/oder durch direkten Kontakt mit der Oberfläche des Grundkörpers aufgetragen wird mit einer Schichtdicke von bis zu 10 µm.

## Claims

1. Device for applying photoresist lacquer to surfaces of a base body having a receiving device (14) for the base body (40), a feeding device (20), moveable relative thereto, for the photoresist lacquer (50), and having means (16) for the defined movement of the base body, the feeding device (20) having at least one point source means (30), **characterised in that**, the point source means (30) has a conical tip (34) for applying the photoresist lacquer (50) at delimited points.

2. Device according to claim 1, **characterised in that** the conical tip is configured as a conically tapered fibre bundle or a capillary system provided with a conically tapered tip.

3. Device according to claim 1 or 2, **characterised in that** the point source means (30) has a pulsed pressure device.

4. Device according to one of the preceding claims, **characterised in that** the conical tip has a curvature radius of between 1µm and 100µm.

5. Device according to one of the preceding claims, **characterised in that** the point source means (30) has a small tube (32) with a storage container (31) for photoresist lacquer (50), in connection therewith a fibre bundle (33) with a conical tip (34), and a heat-shrinkable sleeve (35) connecting the fibre bundle and the small tube.

6. Device according to one of claims 3 or 4, **characterised in that** the pulsed pressure device has nozzle-shaped elements or a nozzle-shaped element (36), an actuator system (37), a storage chamber (38) and/or a storage container for photoresist lacquer and connecting elements (39) to connect nozzle-shaped elements and storage container.

7. Device according to one of the preceding claims **characterised in that** the point source means (30) is a switchable array (80) of nozzles and/or pens.

8. Device according to claim 7, **characterised in that** the switchable array (80) of nozzles and/or pens is configured as a micro-system in the form of a plurality of separately actuatable nozzles or pens.

9. Method of applying photoresist lacquer to a surface of a base body, especially by means of a device according to one of claims 1 to 8, the surface (41) of the base body (40) to be provided with the lacquer and a feeding device (20) for the photoresist lacquer (50) being moved relative to one another in a predeterminable or predetermined manner, the layer thickness of the photoresist lacquer on the surface of the base body being set by variation of the displacement speed of the feeding device for the photoresist lacquer and/or the permeability of one or more point source means (30) of the feeding device (20) and/or the rotational speed of the base body, and the photoresist lacquer being applied at defined points, the conveyance of the photoresist lacquer from the point source means to the surface of the base body to be lacquered taking place as a result of gravitational force or through a pressure regulation of the supply of the photoresist layer from a storage chamber, and the photoresist lacquer being delivered from a conical tip (34) of the point source means.

10. Method according to claim 9, **characterised in that** the photoresist lacquer (50) is guided via conically tapered fibre bundles or a capillary system provided with a conically tapered tip.

11. Method according to claim 9 or 10, **characterised in that** the application of photoresist lacquers of different viscosities and compositions and/or the application of primers or other coupling agents is so controlled that a cohesive layer is produced in a defined region or on the entire surface of the base body.

12. Method according to one of claims 9 to 11, **characterised in that** the application of photoresist lacquer is carried out in a chamber with saturated solvent vapour, portions of the device being disposed in this chamber, especially the base body (40) and the feeding device (20) for the photoresist lacquer (50).

13. Method according to one of claims 9 to 12, **characterised in that** on the surface of the base body, different lacquer layer thicknesses can be applied and/or the photoresist lacquer can be applied in sections or in a small limited area, in a limited homogenous manner locally or in the shape of a line.

14. Method according to one of claims 9 to 13, **characterised in that** the photoresist lacquer is applied in drops from a distance to the surface of the base body onto same and/or through direct contact with the surface of the base body, with a layer thickness of up to 10µm.

## Revendications

1. Dispositif pour appliquer du photorésist à la surface d'un corps de base équipé d'une installation de réception (14) pour le corps de base (40), avec une installation d'alimentation (20) de photorésist (50) mobile par rapport au support et des moyens (16) pour déplacer de manière définie le corps de base, l'installation d'alimentation (20) comportant au moins une source ponctuelle (30),
caractérisé en ce que
la source ponctuelle (30) présente une pointe (34) de forme conique pour appliquer ponctuellement, de manière limitée, le photorésist (50).

2. Dispositif selon la revendication 1,
caractérisé en ce que
la pointe de forme conique est constituée par un faisceau de fibres se rejoignant suivant une forme conique ou par un système capillaire muni d'une pointe se regroupant selon une forme conique.

3. Dispositif selon l'une quelconque des revendications 1 ou 2,
caractérisé en ce que
la source ponctuelle (30) comporte une installation d'impression impulsionnelle.

4. Dispositif selon l'une quelconque des revendications précédentes,
caractérisé en ce que
la pointe de forme conique présente un rayon de courbure de 1 µm à 100 µm.

5. Dispositif selon l'une quelconque des revendications précédentes,
caractérisé en ce que
la source ponctuelle (30) comporte un petit tube (32) avec un réservoir (31) pour le photorésist (50) en liaison avec un faisceau de fibres (33) à pointe (34) de forme conique et un tube rétracté (35) reliant le faisceau de fibres et le petit tube.

6. Dispositif selon l'une quelconque des revendications 3 ou 4,
caractérisé en ce que
l'installation d'impression impulsionnelle comporte des éléments en forme de buse ou un élément en forme de buse (36), un système d'actionneur (37), une chambre d'alimentation (38) et/ou un réservoir d'alimentation en photorésist ainsi que des éléments de liaison (39) pour relier les éléments en forme de buse et le réservoir.

7. Dispositif selon l'une quelconque des revendications précédentes,
caractérisé en ce que
la source ponctuelle (30) est un réseau de buses et/ou de broches (80) commutable.

8. Dispositif selon la revendication 7,
caractérisé en ce que
le réseau de buses et/ou de broches (80), commutable, est une forme de plusieurs buses ou broches à commandes séparées constituant un microsystème.

9. Procédé pour appliquer un photorésist à la surface d'un support, notamment à l'aide d'un dispositif selon l'une des revendications 1 à 8,
selon lequel
- la surface (41) du corps de base (40) à munir de vernis et une installation d'alimentation (20) en photorésist (50) sont déplacées de manière relative de façon prédéterminée ou qui peut être prédéterminée,
- l'épaisseur de la couche de photorésist à la surface du corps de base se règle par variation de la vitesse de déplacement de l'installation d'alimentation en photorésist et/ou la perméabilité d'une ou plusieurs sources ponctuelles (30) de l'installation d'alimentation (20) et/ou la vitesse de rotation du corps de base, et on applique le photorésist de manière définie ponctuellement,
- le transport du photorésist à partir de la source ponctuelle sur la surface à vernir du corps de base se fait sous l'effet de la gravité ou par une régulation de la pression de l'alimentation du photorésist d'une chambre d'alimentation, et l'émission du photorésist se fait à partir de la pointe (34) de forme conique de la source ponctuelle.

10. Procédé selon la revendication 9,
caractérisé en ce que
le photorésist (50) est conduit par un faisceau de fibres se rejoignant suivant une forme conique ou par un système capillaire muni d'une pointe de forme conique.

11. Procédé selon l'une quelconque des revendications 9 et 10,
caractérisé en ce qu'
on commande l'application de photorésist ayant des viscosités et des compositions différentes et/ou des primaires ou autres agents adhésifs, de façon à obtenir une couche cohérente dans une zone définie ou sur toute la surface du corps de base.

12. Procédé selon l'une quelconque des revendications 9 à 11,
caractérisé en ce que
l'application du photorésist (50) se fait dans une chambre saturée en vapeurs de solvant, les parties du dispositif étant installées dans cette chambre notamment le corps de base (40) et l'installation d'alimentation (20) en photorésist (50).

13. Procédé selon l'une quelconque des revendications 9 à 12,
caractérisé en ce qu'
on applique, à la surface du corps de base, des couches de vernis d'épaisseur différentes et/ou on applique le photorésist dans des zones partielles ou dans une petite zone, limitée, localement ou suivant un tracé linéaire pour une application homogène.

14. Procédé selon l'une quelconque des revendications 9 à 13,
caractérisé en ce que
le photorésist est appliqué goutte à goutte à partir d'une distance de la surface du corps de base sur celui-ci et/ou par contact direct avec la surface du corps de base et pour une épaisseur de couche allant jusqu'à 10 µm.
